# EUROPEAN PATENT APPLICATION

(11) **EP 1 586 913 A2**
(43) Date of publication of application: **19.10.2005**
(21) Application number: 04255093.9
(22) Date of filing: 24.08.2004
(51) Int. Cl.: G01R 33/09

(54) **Magnetoresistance effect film and method of manufacturing the same**

(30) Priority: 15.04.2004 JP 2004120696
(71) Applicant: FUJITSU LIMITED, Kawasaki-shi, Kanagawa 211-8588 (JP)
(72) Inventor: Kawai, Kenichi, c/o Fujitsu Limited, Kawasaki-shi Kanagawa 211-8588 (JP)
(74) Representative: Fenlon, Christine Lesley

(57) **Abstract**

The present invention relates to a magnetoresistance effect film that is capable of shortening the time of ion mill treatment and improving the resolution of a read-element. The magnetoresistance effect film includes a protection layer (1, 2), which protects a magnetic layer (4-8) and which is constituted by a specular layer (2) and a cap layer (1). The specular layer (2) and cap layer (1) are made of the same metallic material, and the metallic material of said specular layer (2) is oxidized.

## Description

The present invention relates to a magnetoresistance effect film and a method of manufacturing the magnetoresistance effect film. More precisely, the present invention relates to a magnetoresistance effect film, which is capable of shortening time of ion mill treatment and improving resolution of a read-element, and the method of manufacturing the magnetoresistance effect film.

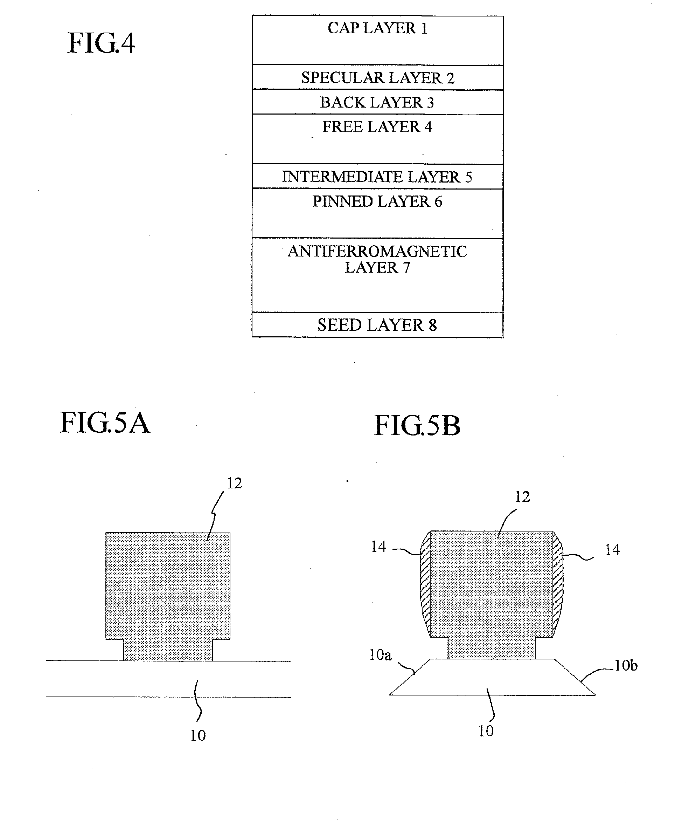

A constitution of a previously-proposed GMR (giant magnetoresistance) film, which is an example of magnetoresistance effect film used in a magnetoresistance effect element, is shown in Fig. 4 of the accompanying drawings. The GMR film is formed by piling a seed layer 8, an antiferromagnetic layer 7, a pinned layer 6, an intermediate layer 5, a free layer 4, a back layer 3, a specular layer 2 and a cap layer 1 in that order.

Various types of GMR films are used. For example, the seed layer 8 is made of NiCr; the antiferromagnetic layer 7 is made of PdPtMn; the pinned layer 6 is made of CoFe/Ru/CoFe; the intermediate layer 5 is made of Cu; the free layer 4 is made of CoFe/NiFe; and the back layer 3 is made of Cu. Further, for example, the specular layer 2 is made of a plasma oxide film of Al; and the cap layer 1 is made of a plasma oxide film of Ta. The plasma oxide film of Al of the specular layer 2 is Al₂O₃, which is oxidized by the steps of: forming an Al film on the back layer 3; introducing Ar and oxygen into an oxidizing chamber, which is separated from a chamber for forming the Al film; and plasma-oxidizing the Al film in the oxidizing chamber.

Fig. 5A of the accompanying drawings shows a step of applying resist 12 on a surface of the GMR film 10; and Fig. 5B of the accompanying drawings shows a step of ion-milling the GMR film 10 so as to form a read-element. In the ion-milling step, ions are diagonally irradiated with respect to the surface of the GMR film 10. The ions are partially sheltered by the resist 12, so that side faces 10a and 10b of the read-element are formed into tapered faces. Electrodes are respectively formed on the tapered faces 10a and 10b. By forming the tapered faces 10a and 10b in the GMR film 10, the electrodes can be easily formed thereon. Further, contact area of the GMR 10 and the electrodes can be broader, so that electrical connection can be secured. The above described GMR film is disclosed in Japanese Patent Gazette 2001-189503.

As described above, after the GMR film 10 is formed, the side faces of the read-element are ion-milled so as to form the tapered faces 10a and 10b. However, the specular layer 2 of the previously-proposed GMR film 10 is made of Al₂O₃, so it takes a long time to execute the ion mill treatment. Therefore, manufacturing efficiency of the magnetoresistance effect film is low. One reason is that Al₂O₃ is hard, so it cannot be easily removed by ion milling; and another reason is that the specular layer 2 is thick, so it takes a long time to execute the ion milling.

As shown in Fig. 5B, film, materials 14 of the GMR film 10 stick on surfaces of the resist 12. If a large amount of the film materials 14 stick on the resist 12, width of the resist 12 is substantially widened, so that width of a read-core is also widened. By widening the read-core, resolution of the read-element must be lower. In the case of the GMR film 10 whose specular layer 2 is made of Al₂O₃, it takes a long time to execute the ion milling, so that thickness of the film materials 14, which stick on the resist 12, is thick. Therefore, the resolution of the read-element must be lower.

Accordingly, it is desirable to solve the above-mentioned problems associated with a previously-proposed magnetoresistance effect film by providing a magnetoresistance effect film, which is capable of shortening time of ion mill treatment and improving resolution of a read-element.

It is also desirable to provide a method of manufacturing such a magnetoresistance effect film.

According to an embodiment of one aspect of the present invention, there is provided a magnetoresistance effect film including a protection layer, which protects a magnetic layer and which is constituted by a specular layer and a cap layer, wherein the specular layer and cap layer are made of the same metallic material, and the metallic material of the specular layer is oxidized.

According to an embodiment of another aspect of the present invention, there is provided a method of manufacturing a magnetoresistance effect film including a protection layer, which protects a magnetic layer and which is constituted by a specular layer and a cap layer, comprises the steps of: forming the specular layer, which is made of a metallic material, on the magnetic layer; oxidizing the metallic material of the specular layer; and forming the cap layer, which is made of the same metallic material.

In an embodiment of the present invention, the metallic material may be Ta. Further, the magnetic layer may be constituted by a seed layer, an antiferromagnetic layer, a pinned layer, an intermediate layer and a free layer, which are formed in that order.

In an embodiment of the present invention, the specular layer and the cap layer, which constitute the protection layer, are made of the same metallic material, and the material of the specular layer is oxidized. Therefore, time for forming a read-element by ion milling can be shortened, and efficiency of manufacturing the magnetoresistance effect film can be improved. Characteristics of a magnetoresistance effect film embodying the present invention are almost equal to those of previously-proposed films.

Reference will now be made, by way of example, to the accompanying drawings, in which:
Fig. 1 is an explanation view showing a constitution of a GMR film manufactured by a method embodying the present invention;
Figs. 2A and 2B are explanation views showing steps of forming a read-element by ion milling;
Fig. 3 is a graph of GMR ratio of the GMR film;
Fig. 4 (as described above) is an explanation view showing a constitution of a previously-proposed GMR film; and
Figs. 5A and 5B (as described above) are explanation views showing steps of forming a previously-proposed read-element.

Preferred embodiments of the present invention will now be described in detail with reference to the accompanying drawings.

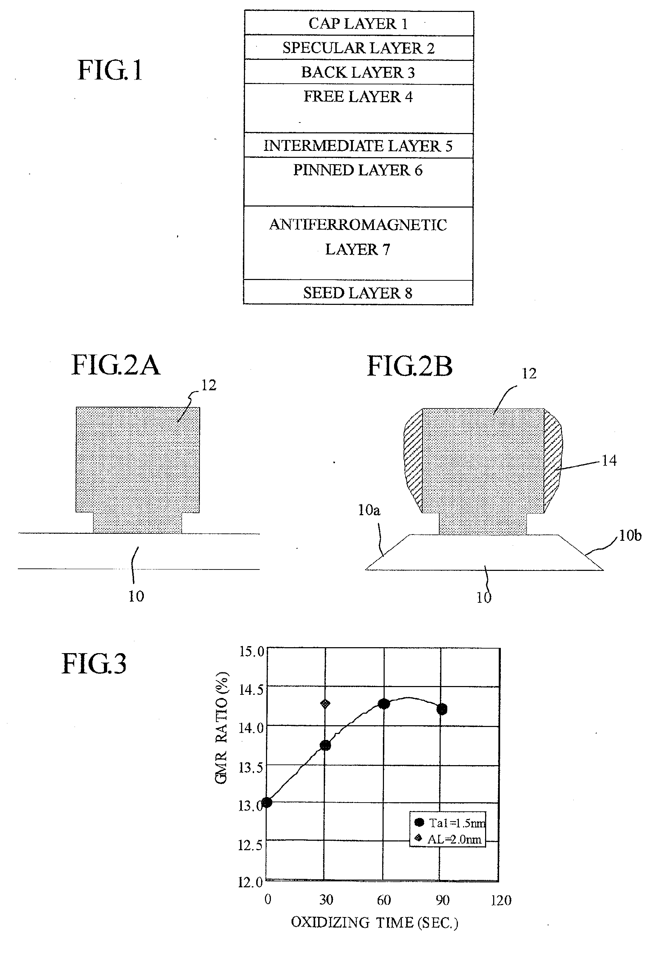

A constitution of a GMR film, which is manufactured by a method embodying the present invention, is shown in Fig. 1. A symbol 1 stands for a cap layer; a symbol 2 stands for a specular layer; a symbol 3 stands for a back layer; a symbol 4 stands for a free layer; a symbol 5 stands for an intermediate layer; a symbol 6 stands for a pinned layer; a symbol 7 stands for an antiferromagnetic layer and a symbol 8 stands for a seed layer. Note that, the constitution from the back layer 3 to the seed layer 8 is the same as that of the GMR film shown in Fig. 4. The feature of the present embodiment is the cap layer 1 and the specular layer 2, especially the specular layer 2.

In the present embodiment, for example, the seed layer 8 is made of NiCr; the antiferromagnetic layer 7 is made of PdPtMn; the pinned layer 6 is made of CoFe/Ru/CoFe; the intermediate layer 5 is made of Cu; the free layer 4 is made of CoFe/NiFe; and the back layer 3 is made of Cu. Further, the specular layer 2 is made of plasma oxide film of Ta; and the cap layer 1 is made of Ta film.

Fig. 1 shows the relative thickness of each layer of the GMR film of the present embodiment, and Fig. 4 shows that of the previously-proposed GMR film described hereinabove. According to Figs. 1 and 4, thickness of the layers 3 to 8 shown in Fig. 1 are equal to thickness of the layers 3 to 8 shown in Fig. 4.

In the previously-proposed GMR film shown in Fig. 4, the specular layer is made of plasma oxide film of Al; in the present embodiment, the specular film 2 is made of plasma oxide film of Ta. The plasma oxide film of Ta is formed by the steps of: forming Ta film on a surface of the back layer 3; and oxidizing the Ta film in an oxidizing chamber, which is separated from a chamber in which the Ta chamber has been formed. Namely, Ar and oxygen are introduced into the oxidizing chamber, then the Ta film is plasma-oxidized therein so that plasma oxide film of Ta (Ta₂O₅) can be formed.

In the previously-proposed GMR film shown in Fig. 4, when the specular layer is formed, firstly the Al film is grown until reaching thickness of 2 nm, then the Al film is plasma-oxidized. On the other hand, in the present embodiment, the Ta film is grown until reaching thickness of 1.5 nm, then the Ta film is plasma-oxidized. Therefore, the specular layer 2 of the present embodiment is slightly thinner than the specular layer of the previously-proposed GMR film.

Further, thickness of the cap layer of the previously-proposed GMR film is 3 nm; thickness of the cap layer 1 of the present embodiment is 1.5 nm.

In comparison with the previously-proposed specular layer made of plasma oxide film of Al, the specular layer 2 of the present embodiment, which is made of plasma oxide film of Ta, can be easily etched by ion milling. Therefore, time for etching the GMR film of the present embodiment by ion milling can be shortened.

Etching rate ratio of the previously-proposed GMR film, whose specular layer is made of plasma oxide film (Al₂O₃) and whose cap layer is made of Ta, and that of the GMR film of the present embodiment, whose specular layer 2 is made of plasma oxide film (Ta₂O₅) and whose cap layer 1 is made of Ta, are shown in the following table (TABLE).

| | | |
|---|---|---|
| | PREVIOUSLY-PROPOSED GMR FILM | GMR FILM OF THE PRESENT EMBODIMENT |
| THICKNESS OF LAYERS (SPECULAR LAYER /CAP LAYER) | Al₂O₃(2nm)/Ta(3nm) | Ta₂O₅(1.5nm)/Ta(1.5nm) |
| ETCHING RATE RATIO | 4 | 1 |

According to the TABLE, speed of etching (or ion-milling) the GMR film of the present embodiment is four times faster than that of etching the previously-proposed GMR film. In the present embodiment, the thickness of the specular layer 2 is thinner than that of the previously-proposed specular layer made of Al₂O₃, the thickness of the cap layer 1 is also thinner than that of the previously-proposed cap layer. However, a main reason of the difference of the etching rate ratio between the two is to employ the plasma oxide film of Ta, e.g., Ta₂O₅, instead of the plasma oxide film of Al because Ta can be easily ion-milled.

The inventor compared the time of completely etching the previously-proposed GMR film with the time of completely etching the GMR film of the present embodiment under the conditions shown in the TABLE. The time for completely etching the GMR film of the present embodiment was about 50 % of the time for completely etching the previously-proposed GMR film. According to the result, the time for ion milling the GMR film can be effectively shortened by employing the specular layer 2 made of the plasma oxide film of Ta and the cap layer 1 made of the Ta film.

Figs. 2A and 2B show the steps of forming a read-element by ion milling the GMR film 10, in which the specular layer 2 is made of the plasma oxide film of Ta and the cap layer 1 is made of the Ta film. In Fig. 2A, resist 12 is applied on a surface of the GMR film 10; in Fig. 2B, tapered faces 10a and 10b are respectively formed on both sides of a read-element by ion-milling the GMR film 10. Since the GMR film 10 of the present embodiment can be ion-milled in a short time, amount of a film material 14 sticking on the resist 12 can be reduced so that extension of width of the resist 12 can be substantially restricted. Therefore, core width of the read-element can be restricted, and resolution of the read-element can be improved.

In the present embodiment, after the Ta film is formed on the surface of the back layer 3, the Ta film is plasma-oxidized in the oxidizing chamber so as to form the specular layer 2. Variation of GMR ratio of the GMR film, which was oxidized in the oxidizing chamber, with respect to oxidizing time was observed. The result is shown in Fig. 3. The experiment was executed under the conditions shown in the TABLE. The result of the previously-proposed GMR film, whose specular layer was made of plasma oxide film of Al shown in the TABLE, is also shown in Fig. 3 as a comparable example.

According to Fig. 3, when the Ta film was plasma-oxidized for 30 seconds, the GMR ratio was lower than that of the comparable example, namely oxidization was not enough. When the Ta film was plasma-oxidized for 60-90 seconds, the GMR ratio was almost equal to that of the comparable example. Namely, by employing the plasma oxide film of Ta, which is formed by plasma-oxidizing the Ta film for 60-90 seconds, as the specular layer 2, the GMR film 10 can be suitably used for the magnetoresistance effect element.

The present invention may be embodied in other specific forms without departing from the spirit of essential characteristics thereof.

## Claims

1. A magnetoresistance effect film including a protection layer (1, 2), which protects a magnetic layer (4-8) and which is constituted by a specular layer (2) and a cap layer (1),
wherein said specular layer (2) and cap layer (1) are made of the same metallic material, and
the metallic material of said specular layer (2) is oxidized.

2. The magnetoresistance effect film according to claim 1,
wherein the metallic material is Ta.

3. The magnetoresistance effect film according to claim 1 or 2,
wherein said magnetic layer (4-8) is constituted by a seed layer (8), an antiferromagnetic layer (7), a pinned layer (6), an intermediate layer (5) and a free layer (4), which are piled in that order.

4. A method of manufacturing a magnetoresistance effect film including a protection layer (1, 2), which protects a magnetic layer (4-8) and which is constituted by a specular layer (2) and a cap layer (1),
comprising the steps of:
forming said specular layer (2), which is made of a metallic material, on said magnetic layer (4-8);
oxidizing the metallic material of said specular layer (2); and
forming said cap layer (1), which is made of the same metallic material.

5. The method according to claim 4,
wherein the metallic material is Ta.

6. The method according to claim 4 or 5,
wherein said magnetic layer (4-8) is constituted by a seed layer (8), an antiferromagnetic layer (7), a pinned layer (6), an intermediate layer (5) and a free layer (4), which are formed in that order, and
said protection layer (1, 2) is formed on said magnetic layer (4-8).
